# DEMANDE DE BREVET EUROPEEN

(11) **EP 4 068 386 A1**
(43) Date de publication de la demande: **05.10.2022**
(21) Numéro de dépôt: 22164583.1
(22) Date de dépôt: 25.03.2022
(51) Int. Cl.: H01L 29/20, H01L 29/205, H01L 29/423, H01L 29/78, H01L 29/04, H01L 29/66

(54) **TRANSISTOR À EFFET DE CHAMP À STRUCTURE VERTICALE**

(30) Priorité: 29.03.2021 FR 2103210
(71) Demandeur: Commissariat à l'Energie Atomique et aux Energies Alternatives, 75015 Paris (FR)
(72) Inventeur: BUCKLEY, Julien, 38054 GRENOBLE CEDEX 9 (FR); CHARLES, Matthew, 38054 GRENOBLE CEDEX 09 (FR)
(74) Mandataire: Cabinet Camus Lebkiri

(57) **Abrégé**

Un aspect de l'invention concerne un transistor à effet de champ (20) comprenant :
- une couche de semi-conducteur III-N (21) comprenant une première face (21a) et une deuxième face (21b) opposée à la première face, la première face (21a) présentant une polarité de type azote (N) ;
- une couche de dérive (22) disposée sur la première face (21a) de la couche de semi-conducteur III-N (21) ;
- une couche de canal (23) disposée sur la couche de dérive (22) et formant une hétérostructure avec la couche de dérive (22) ;
- une structure de grille (27) s'étendant jusqu'à la couche de dérive (22) à travers la couche de canal (23) ;
- une électrode de source (25) disposée sur la couche de canal (23) ; et
- une électrode de drain (26) disposée sur la deuxième face (21b) de la couche de semi-conducteur III-N (21).

## Description

### DOMAINE TECHNIQUE

Le domaine technique de l'invention est celui de l'électronique de puissance. La présente invention concerne un transistor à effet de champ à structure verticale, fabriqué à partir d'un substrat en matériau semiconducteur III-N tel que le nitrure de gallium (GaN).

### ÉTAT DE LA TECHNIQUE

Un transistor à haute mobilité d'électrons (ou HEMT, pour « High Electron Mobility Transistor » en anglais) est un transistor à effet de champ bénéficiant des propriétés de conduction d'un gaz d'électrons bidimensionnel (ou 2DEG, pour « 2-Dimensional Electron Gas » en anglais). Il comprend un empilement vertical de couches de semi-conducteur III-N sur un substrat, typiquement en silicium, carbure de silicium ou saphir. Le gaz d'électrons bidimensionnel est formé par une hétérojonction entre une couche de canal, typiquement en nitrure de gallium (GaN), et une couche de barrière, typiquement en nitrure d'aluminium-gallium (AlGaN).

Ce transistor à hétérojonction est qualifié de transistor à structure latérale, car l'électrode de source, l'électrode de drain et l'électrode de grille du transistor sont disposés d'un même côté du substrat, l'électrode de source et l'électrode de drain étant situées de part et d'autre de l'électrode de grille.

Le HEMT supporte des densités de courant élevées à l'état passant, en raison de la forte densité de porteurs de charge et de la grande mobilité de ces porteurs dans le gaz d'électrons bidimensionnel. Il peut également présenter une vitesse de commutation élevée.

En revanche, il présente une tension de seuil relativement faible, généralement comprise entre 1 V et 3 V, ce qui s'avère insuffisant pour certaines applications, comme les applications automobiles de haute puissance par exemple. Par ailleurs, pour obtenir une bonne tenue en tension dans l'état bloqué, autrement dit une tension de claquage élevée, un espacement important entre l'électrode de grille et l'électrode de drain est nécessaire, ce qui augmente l'encombrement du transistor.

Un transistor GaN à structure verticale peut au contraire présenter une tension de claquage élevée sans augmenter la surface du composant, en jouant sur l'épaisseur d'une couche active appelée couche de dérive (« drift layer » en anglais). Ce type de transistor est généralement formé à partir d'un substrat autoportant en GaN.

Le document [« 1.8 mΩ.cm2 vertical GaN-based trench metal-oxide-semiconductor field-effect transistors on a free-standing GaN substrate for 1.2-kV-class opération », Tohru Oka et al., Appl. Phys. Express 8, 054101, 2015] décrit un exemple de transistor GaN vertical, de type MOSFET à tranchée.

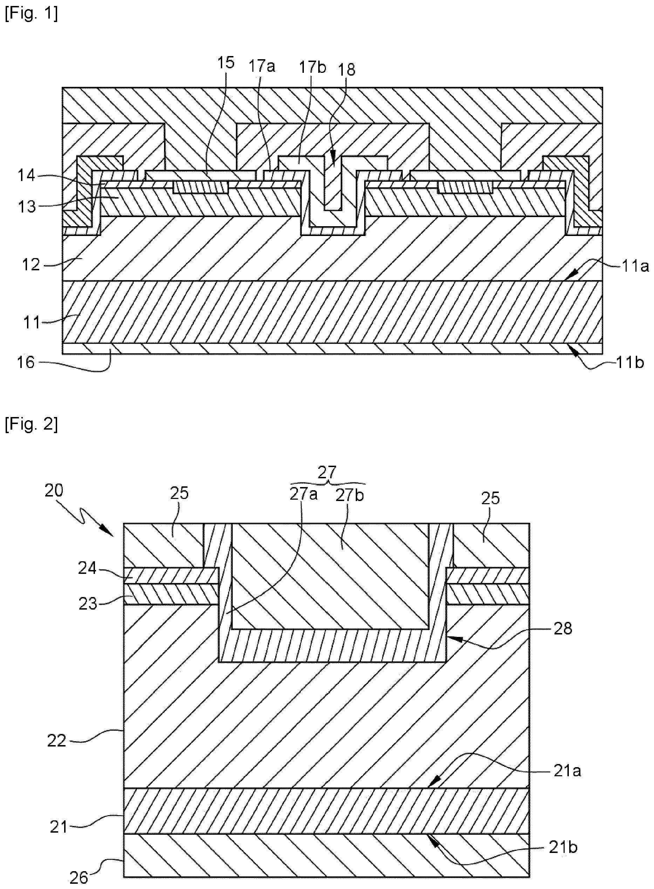

En référence à la figure 1, ce transistor 10 comprend un substrat 11 en GaN fortement dopé n (n⁺-GaN), une couche de dérive 12 en GaN faiblement dopé n (n⁻-GaN) disposée sur une première face 11a du substrat 11, une couche de canal 13 en GaN dopé p (p-GaN) disposée sur la couche de dérive 12 et une couche de contact de source 14 en GaN fortement dopé n (n⁺-GaN) disposée sur la couche de canal 13. Une électrode de source 15 est disposée sur la couche de contact de source 14, tandis qu'une électrode de drain 16 est disposée sur une deuxième face opposée 11b du substrat 11. Enfin, une couche diélectrique de grille 17a et une électrode de grille 17b sont disposées au fond et contre les parois latérales d'une tranchée 18. La tranchée 18 s'étend jusqu'à la couche de dérive 12 à travers la couche de canal 13 et la couche de contact de source 14.

Le transistor 10 de la figure 1 présente une tension de claquage élevée, de l'ordre de 1,2 kV, et un encombrement réduit. En revanche, sa tension de seuil est limitée à 3,5 V malgré une concentration élevée de dopants dans la couche de canal 13 en p-GaN.

### RÉSUMÉ DE L'INVENTION

On constate donc que le besoin d'un transistor de puissance ayant une tension de seuil élevée n'est pas satisfait.

Selon un premier aspect de l'invention, on tend à satisfaire ce besoin en prévoyant un transistor à effet de champ comprenant :
- une couche de semi-conducteur III-N comprenant une première face et une deuxième face opposée à la première face ;
- une couche de dérive disposée sur la première face de la couche de semi-conducteur III-N ;
- une couche de canal disposée sur la couche de dérive ;
- une structure de grille s'étendant jusqu'à la couche de dérive à travers la couche de canal ;
- une électrode de source disposée sur la couche de canal ; et
- une électrode de drain disposée sur la deuxième face de la couche de semi-conducteur III-N.

Ce transistor à structure verticale est remarquable en ce que la première face de la couche de matériau semi-conducteur III-N présente une polarité de type azote (N) et en ce que la couche de canal forme une hétérostructure avec la couche de dérive.

En disposant successivement la couche de dérive et la couche de canal sur la face azote de la couche de matériau semi-conducteur III-N (plutôt que la face gallium dans l'exemple d'un substrat en GaN), une charge piézoélectrique négative se forme à l'interface entre la couche de dérive et la couche de canal. Cette charge négative a pour effet de relever la bande de conduction à cette interface, créant une barrière de potentiel élevée qui s'oppose au passage du courant. Il en résulte une augmentation significative de la tension de seuil du transistor.

Un matériau semi-conducteur III-N désigne un matériau de la famille des nitrures comprenant (en plus de l'azote) un ou plusieurs éléments du groupe 13 (colonne IIIA dans le système CAS nord-américain) du tableau périodique des éléments.

La couche de semi-conducteur III-N peut être en nitrure de gallium (GaN) ou en nitrure d'aluminium-gallium (AlGaN).

Dans un mode de réalisation préférentiel du transistor, la couche de dérive est en nitrure de gallium (GaN) dopé n et la couche de canal est en nitrure d'aluminium-gallium (AlGaN) dopé p ou non-intentionnellement dopé.

Selon un développement de ce mode de réalisation préférentiel, le nitrure d'aluminium-gallium (AlGaN) de la couche de canal présente un pourcentage d'aluminium compris entre 20 % et 40 %.

Selon un autre développement, la couche de canal présente une épaisseur comprise entre 10 nm et 20 nm.

Dans une variante de réalisation, la couche de dérive est en nitrure d'aluminium-gallium (AlGaN) dopé n et la couche de canal est en nitrure d'aluminium (AlN) dopé p ou non-intentionnellement dopé.

Dans une autre variante de réalisation, la couche de dérive est en nitrure d'aluminium-gallium (AlGaN) dopé n et la couche de canal est en un nitrure d'aluminium-gallium (AlGaN) dopé p ou non-intentionnellement dopé et présentant un pourcentage d'aluminium supérieur à celui de la couche de dérive.

Le transistor selon le premier aspect de l'invention peut également présenter une ou plusieurs des caractéristiques ci-dessous, considérées individuellement ou selon toutes les combinaisons techniquement possibles :
- le matériau semi-conducteur III-N est de préférence dopé de type n ;
- l'électrode de drain est en contact électrique avec la couche de semi-conducteur III-N ;
- l'électrode de source est en contact électrique avec la couche de canal ;
- le transistor comprend en outre une couche de contact de source disposée entre la couche de canal et l'électrode de source ;
- la couche de contact de source est en nitrure de gallium (GaN) dopé de type n ; et
- la couche de contact de source forme une hétérostructure avec la couche de canal.

Un deuxième aspect de l'invention concerne un procédé de fabrication d'un transistor à effet de champ, comprenant les étapes suivantes :
- fournir un substrat en un matériau semi-conducteur III-N, le substrat comprenant une première face présentant une polarité de type azote (N) et une deuxième face opposée à la première face ;
- former successivement par épitaxie une couche de dérive et une couche de canal sur la première face du substrat, la couche de canal formant une hétérostructure avec la couche de dérive ;
- former une structure de grille s'étendant jusqu'à la couche de dérive à travers la couche de canal ;
- former une électrode de source sur la couche de canal ; et
- former une électrode de drain sur la deuxième face du substrat.

Le procédé peut comprendre en outre une étape d'amincissement du substrat avant l'étape de formation de l'électrode de drain.

Un troisième aspect de l'invention concerne un procédé de fabrication d'un transistor à effet de champ, comprenant les étapes suivantes :
- fournir un substrat de croissance comprenant une couche en un matériau semi-conducteur III-N, le substrat de croissance comprenant une première face présentant une polarité de type groupe III ;
- former un empilement en faisant croître successivement par épitaxie une couche de canal, une couche de dérive et une couche de semi-conducteur III-N sur la première face du substrat de croissance, la couche de canal formant une hétérostructure avec la couche de dérive ;
- déposer au moins une couche métallique sur la couche de semi-conducteur III-N pour former une électrode de drain ;
- retourner l'empilement et le coller à un substrat de report du côté de l'électrode de drain ;
- retirer le substrat de croissance ;
- former une structure de grille s'étendant jusqu'à la couche de dérive à travers la couche de canal ; et
- former une électrode de source sur la couche de canal.

Le substrat de report est avantageusement en métal.

De préférence, l'empilement comprend en outre une couche d'arrêt formée par épitaxie sur la première face du substrat de croissance avant la couche de canal. La couche d'arrêt est par exemple en nitrure d'aluminium-gallium (AlGaN).

L'invention et ses différentes applications seront mieux comprises à la lecture de la description qui suit et à l'examen des figures qui l'accompagnent.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures suivantes :
la figure 1, précédemment décrite, est une vue en coupe d'un transistor à effet de champ selon l'art antérieur ;
la figure 2 représente schématiquement un transistor à effet de champ selon le premier aspect de l'invention ;
la figure 3 représente l'énergie de la bande de conduction sous deux tensions de polarisation V_{DS} différentes et la charge piézoélectrique dans un exemple de transistor selon la figure 2 ;
la figure 4 montre des caractéristiques I_{D}-V_{GS} d'un exemple de transistor selon la figure 2, ces caractéristiques correspondant à différents pourcentages d'aluminium dans une couche de canal en AlGaN ;
la figure 5 montre des caractéristiques I_{D}-V_{GS} d'un exemple de transistor selon la figure 2, ces caractéristiques correspondant à différentes épaisseurs d'une couche de canal en AlGaN ;
les figures 6A à 6H représentent des étapes d'un procédé de fabrication de transistor à effet de champ selon le deuxième aspect de l'invention ; et
les figures 7A à 7D représentent des étapes d'un procédé de fabrication de transistor à effet de champ selon le troisième aspect de l'invention.

Pour plus de clarté, les éléments identiques ou similaires sont repérés par des signes de référence identiques sur l'ensemble des figures.

### DESCRIPTION DÉTAILLÉE

La figure 2 est une vue en coupe schématique d'un transistor à effet de champ 20 selon un aspect de l'invention. Ce type de transistor trouve des applications avantageuses en électronique de puissance, par exemple en tant qu'interrupteur de puissance dans des convertisseurs abaisseurs ou élévateurs de tension (convertisseurs « buck » ou « boost ») ou des convertisseurs courant continu - courant alternatif. Le transistor peut ainsi commuter de manière réversible entre un premier état appelé « état passant » (ou « état ON ») et un deuxième état appelé « état bloqué » (ou « état OFF »).

Le transistor à effet de champ 20 comprend :
- une couche de semi-conducteur III-N 21 ayant une première face 21a et une deuxième face 21b opposée à la première face 21a ;
- une couche de dérive 22 (« drift layer » en anglais) disposée sur la première face 21a de la couche de semi-conducteur III-N 21 ;
- une couche de canal 23 disposée sur la couche de dérive 22 ;
- une électrode de source 25 disposée sur la couche de canal 23 ;
- une électrode de drain 26 disposée sur la deuxième face 21b de la couche de semi-conducteur III-N 21 ; et
- une structure de grille 27 s'étendant jusqu'à la couche de dérive 22 à travers la couche de canal 23.

La couche de semi-conducteur III-N 21 est constituée d'un premier matériau semi-conducteur III-N à structure de maille hexagonale, par exemple le nitrure de gallium (GaN) ou le nitrure d'aluminium-gallium (AlGaN) (les atomes d'aluminium se substituant à une partie des atomes de gallium dans l'AlGaN). La première face 21a présente une polarité de type azote (N), tandis que la deuxième face 21b présente une polarité du type groupe III (gallium, aluminium, indium...). La notion de polarité est décrite en détail dans l'ouvrage de référence [« Gallium nitride electronics », Rüdiger QUAY, Springer Science & Business Media, pp.29-30, 2008].

La couche de semi-conducteur III-N 21 peut être un substrat autoportant en matériau semi-conducteur III-N ou un substrat massif en matériau semi-conducteur III-N, sur lequel ont été formées successivement la couche de dérive 22 et la couche de canal 23. Un substrat autoportant est obtenu par épitaxie d'une couche épaisse sur un substrat de croissance puis retrait du substrat de croissance, alors qu'un substrat massif est obtenu par tirage et découpage d'un lingot. Alternativement, la couche de semi-conducteur III-N 21 peut être une couche épitaxiée sur un substrat de croissance, ce substrat de croissance n'étant retiré qu'après la formation de la couche de dérive 22 et la couche de canal 23. Le substrat de croissance est par exemple en saphir, en carbure de silicium ou en silicium.

Dans un souci de simplification, on utilisera par la suite le terme de « substrat » pour désigner la couche de semi-conducteur III-N 21 du transistor 20.

Le premier matériau semi-conducteur III-N est de préférence dopé de type n. La concentration en impuretés dopantes de type n (par exemple des atomes de silicium) du substrat 21 est de préférence comprise entre 10¹⁷ cm⁻³ et 10²⁰ cm⁻³, par exemple égale à 10¹⁸ cm⁻³.

Le transistor 20 est à structure verticale, car l'électrode de source 25 et l'électrode de drain 26 sont disposées de part et d'autre du substrat 21.

La couche de dérive 22 (« drift layer » en anglais), aussi appelée couche de tenue en tension, est constituée d'un deuxième matériau semi-conducteur III-N, par exemple le nitrure de gallium (GaN) ou le nitrure d'aluminium-gallium (AlGaN). Le deuxième matériau semi-conducteur III-N, qui peut être identique ou différent du premier matériau semi-conducteur III-N (substrat 21), est de préférence dopé de type n. La concentration en impuretés dopantes de type n de la couche de dérive 22 est avantageusement inférieure à celle du substrat 21. Elle est de préférence comprise entre 10¹⁴ cm⁻³ et 10¹⁷ cm⁻³, par exemple égale à 10¹⁶ cm⁻³. L'épaisseur de la couche de dérive 22 est avantageusement supérieure à 10 µm afin de conférer au transistor 20 une bonne tenue en tension (tension drain-source V_{DS}), par exemple d'au moins 1000 V.

La couche de canal 23 est la couche dans laquelle se forme le canal de conduction du transistor 20, le long d'un flanc de la structure de grille 27. Elle est constituée d'un troisième matériau semi-conducteur III-N et forme une hétérostructure avec la couche de dérive 22. Le troisième matériau semi-conducteur III-N (couche de canal 23) présente donc une largeur de bande interdite différente de celle du deuxième matériau semi-conducteur III-N (couche de dérive 22). La largeur de bande interdite du troisième matériau semi-conducteur III-N est avantageusement supérieure à celle du deuxième matériau semi-conducteur III-N, afin de créer une barrière de potentiel (due au décalage des bandes de conduction), aussi appelée barrière tunnel, dans le sens de circulation des porteurs de charge, ici des électrons provenant de la source et se déplaçant en direction du drain. Le troisième matériau semi-conducteur III-N peut être dopé de type p ou non intentionnellement dopé. L'épaisseur de la couche de canal 23 peut être comprise entre 10 nm et 30 nm.

Dans un mode de réalisation préférentiel du transistor 20, la couche de dérive 22 est en GaN dopé n (10¹⁴ cm⁻³-10¹⁷ cm⁻³) et la couche de canal 23 est en AlGaN dopé p ou non-intentionnellement dopé. Le substrat 21 est avantageusement en GaN dopé n (10¹⁷ cm⁻³-10²⁰ cm⁻³) pour minimiser les défauts de croissance dans la couche de dérive 22 en n-GaN.

Dans une variante de réalisation, la couche de dérive 22 est en AlGaN dopé n (10¹⁴ cm⁻³-10¹⁷ cm⁻³) et la couche de canal 23 est en nitrure d'aluminium (AlN) dopé p ou non-intentionnellement dopé. Dans une autre variante de réalisation, la couche de dérive 22 est en AlGaN dopé n (10¹⁴ cm⁻³-10¹⁷ cm⁻³) et la couche de canal 23 est en AlGaN dopé p ou non-intentionnellement dopé avec une concentration en aluminium supérieure à celle de la couche de dérive 22. Dans ces deux variantes de réalisation, le substrat 21 est avantageusement en AlGaN dopé n (10¹⁷ cm⁻³-10²⁰ cm⁻³) pour minimiser les défauts de croissance dans la couche de dérive 22 en n-AlGaN.

De façon avantageuse, le transistor 20 comprend en outre une couche de contact de source 24 disposée entre la couche de canal 23 et l'électrode de source 25. La couche de contact de source 24 améliore la qualité du contact électrique entre la couche de canal 23 et l'électrode de source 25.

La couche de contact de source 24 est de préférence constituée d'un quatrième matériau semi-conducteur III-N dopé n, de préférence à une concentration comprise entre 10¹⁸ cm⁻³ et 10²⁰ cm⁻³ afin de former un contact (ohmique) faiblement résistif avec l'électrode de source 25. La couche de contact de source 24 peut former une deuxième hétérostructure avec la couche de canal 23. Le quatrième matériau semi-conducteur III-N est alors différent du troisième matériau semi-conducteur III-N (couche de canal 23). Il est de préférence identique au premier matériau semi-conducteur III-N (substrat 21).

En l'absence de la couche de contact de source 24, l'électrode de source 25 est en contact direct avec la couche de canal 23.

La structure de grille 27 du transistor 20 est de préférence une structure de grille MOS (Métal-Oxyde-Semi-conducteur). Elle comprenant une couche diélectrique de grille 27a et une électrode de grille 27b séparée de la couche de canal 23 (et de la couche de contact de source 24, le cas échéant) par la couche diélectrique de grille 27a. Le transistor 20 est alors un transistor à effet de champ métal-oxyde-semi-conducteur (MOSFET), ici à canal n (n-MOSFET) étant donné le type de conductivité du substrat 21 (côté drain) et de la couche de contact de source 24 (côté source).

La couche diélectrique de grille 27a est par exemple en dioxyde de silicium (SiO₂). L'électrode de grille 27b est de préférence en métal, par exemple en nitrure de titane (TiN).

La structure de grille 27 est disposée dans une tranchée 28, qui s'étend jusqu'à la couche de dérive 22 à travers la couche de canal 23, et le cas échéant, la couche de contact de source 24 (on parle alors de MOSFET à tranchée, ou « Trench-MOSFET » en anglais).

L'électrode de source 25 et l'électrode de grille 27b peuvent comporter chacune plusieurs portions. Les portions d'une même électrode sont reliées électriquement entre elles afin d'être soumises au même potentiel électrique. Dans un souci de clarté, seule une portion de l'électrode de grille 27a et deux portions de l'électrode de source 25, disposées de part et d'autre de la portion de l'électrode de grille 27a, ont été représentées sur la figure 2. Les portions de l'électrode de source 25 sont avantageusement imbriquées avec les portions de l'électrode de grille 27a afin de diminuer la résistance du transistor 20 dans l'état passant. Plusieurs agencements sont possibles pour l'électrode de source 25 et l'électrode de grille 27b : peignes interdigités, structures à cellules hexagonales comme décrit dans le document [« 1.8 mΩ.cm2 vertical GaN-based trench metal-oxide-semiconductor field-effect transistors on a free-standing GaN substrate for 1.2-kV-class opération », Tohru Oka et al., Appl. Phys. Express 8, 054101, 2015]...

A l'instar de l'électrode de source 25 avec la couche de canal 23, l'électrode de drain 26 est en contact électrique (ohmique) avec le substrat 21 en matériau semi-conducteur III-N. L'électrode de source 25 et l'électrode de drain 26 sont de préférence en métal, par exemple en TiN ou TiN sur Ti (bicouche).

Une particularité du transistor à effet de champ 20 est que la couche de dérive 22, la couche de canal 23 et la couche de contact de source 24 (lorsque cette dernière est souhaitée) sont empilées sur la face de polarité N du substrat 21, plutôt que sur la face de polarité Ga comme dans les transistors GaN verticaux de l'art antérieur.

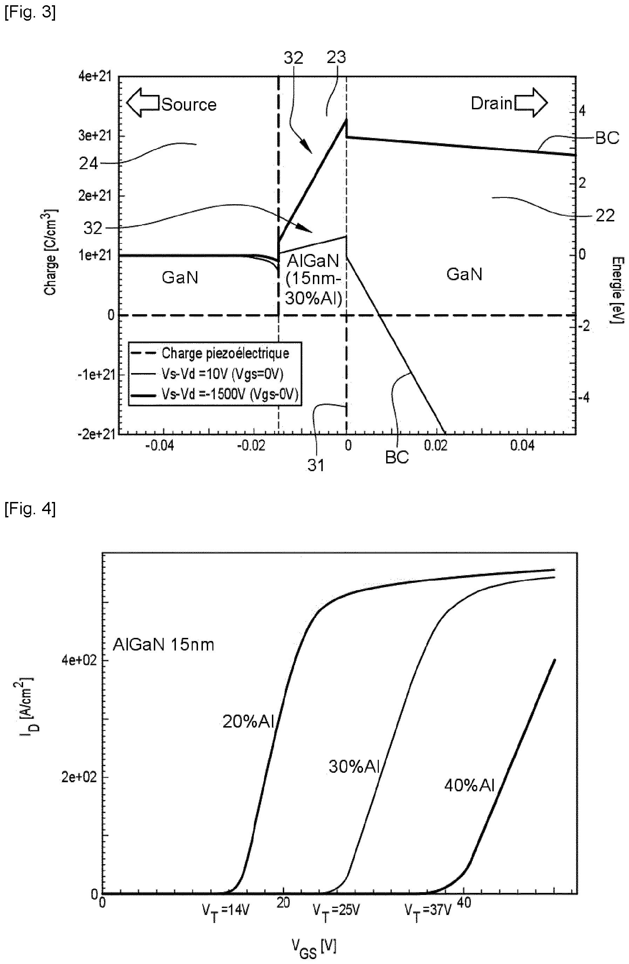

La figure 3 montre l'impact de la polarisation du substrat 21 sur la charge piézoélectrique et le diagramme de la bande de conduction dans un exemple de transistor 20 comprenant une couche de dérive 22 en n-GaN, une couche de canal 23 en AlGaN (15 nm d'épaisseur et 30 % d'aluminium) et une couche de contact de source 24 en n-GaN.

Une charge piézoélectrique négative 31 se forme à l'interface entre la couche de dérive 22 (en GaN) et à la couche de canal 23 (en AlGaN), autrement dit à l'hétérojonction. Le champ électrique induit par cette charge d'interface négative relève la bande de conduction BC à l'interface, créant ainsi une barrière de potentiel 32 qui s'oppose à la circulation des électrons (de la source vers le drain) lorsque le transistor 20 est dans l'état bloqué (V_{GS} < V_{T}, par exemple V_{GS} = 0 sur la figure 3). La hauteur de la barrière de potentiel 32 est significative, de l'ordre de plusieurs électron-volts, à une tension drain source V_{DS} nulle ou négative (par exemple égale à -10 V) et reste présente à une tension V_{DS} positive élevée (par exemple égale à 1500 V). Ainsi, un blocage du transistor peut être assuré même sous une forte tension V_{DS}.

L'augmentation de la barrière de potentiel 32 se traduit par une augmentation significative de la tension de seuil V_{T} du transistor, c'est-à-dire la tension grille-source V_{GS} à partir de laquelle le transistor devient passant.

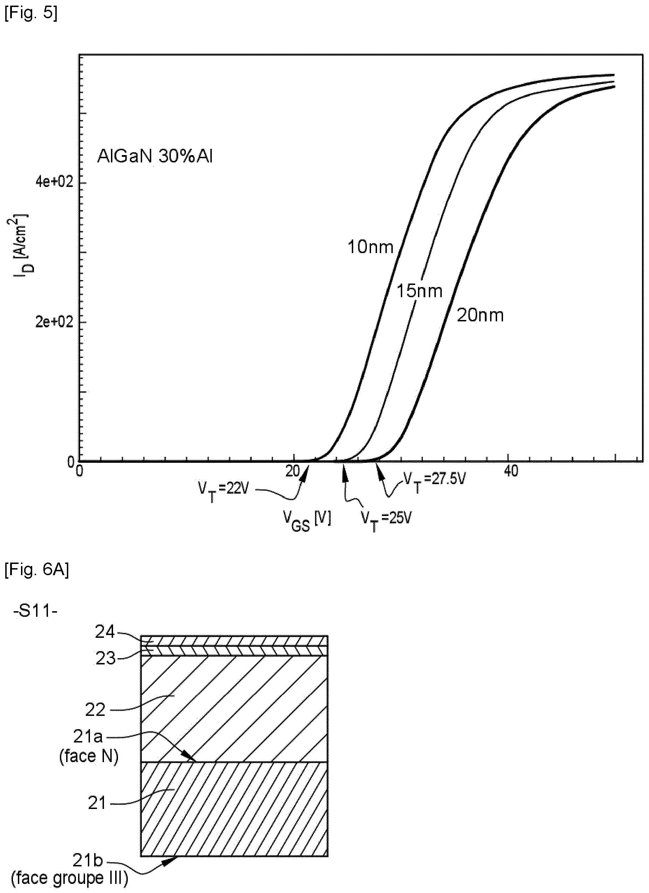

La figure 4 représente le courant de drain I_{D} en fonction de la tension grille-source V_{GS} du transistor 20, pour plusieurs valeurs du taux d'aluminium dans la couche de canal 23 en AlGaN (et une épaisseur constante de 15 nm). La figure 5 représente le courant de drain I_{D} en fonction de la tension grille-source V_{GS} du transistor 20, pour plusieurs valeurs d'épaisseur de la couche de canal 23 en AlGaN (et une taux d'aluminium constant de 30 %).

Ces figures montrent que la tension de seuil V_{T} du transistor 20 est largement supérieure à 5 V et augmente avec le taux d'aluminium dans la couche de canal 23 en AlGaN ou avec l'épaisseur de la couche de canal 23. Cela est dû au fait que le décalage des bandes de conduction entre le GaN et l'AlGaN (aux interfaces couche de dérive 22 - couche de canal 23 et couche de canal 23 - couche de contact de source 24) augmente avec le taux d'aluminium ou avec l'épaisseur de la couche de canal 23.

Une concentration en aluminium comprise entre 20 % et 40 % et une épaisseur comprise entre 10 nm et 20 nm constituent de bons compromis entre tension de seuil suffisamment élevée, facilité de réalisation du circuit de commande du transistor et fuites de courant dans l'état bloqué.

Le dopage p de la couche de canal 23 apporte un degré supplémentaire d'ajustement de la tension de seuil V_{T} du transistor 20 : la concentration en impuretés dopantes de type p.

Deux procédés de fabrication du transistor à effet de champ 20 selon la figure 2 vont maintenant être décrits. Dans ces procédés, il est considéré que le transistor 20 comprend la couche de contact de source 24. Cependant, cette couche pourrait être omise.

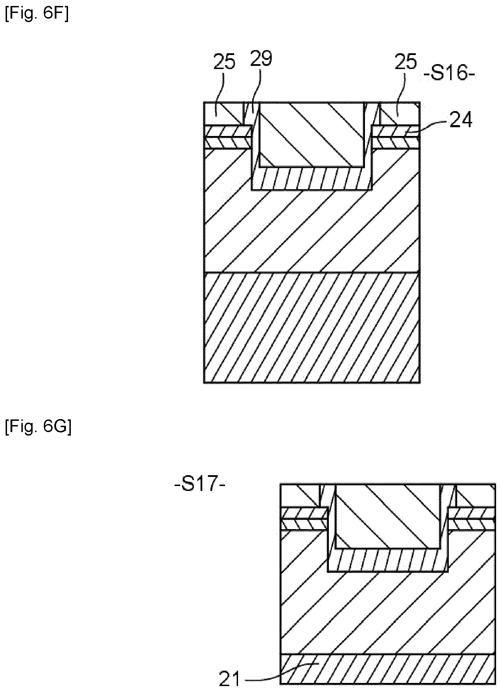

Les figures 6A à 6H représentent schématiquement des étapes S11 à S18 d'un premier procédé de fabrication.

Ce premier procédé de fabrication comprend initialement la fourniture d'un substrat autoportant 21 en matériau semi-conducteur III-N. Ce substrat 21 possède une première face 21a de polarité azote (« face N ») et une deuxième face 21b, opposée à la première face 21a et de polarité de type groupe III (« face groupe III »). Son épaisseur est par exemple de 400 µm.

La fourniture du substrat 21 peut comporter une opération de croissance d'une couche de matériau-semiconducteur III-N sur un substrat hôte, par exemple en silicium, carbure de silicium ou saphir, puis une opération de retrait du substrat hôte, par exemple par découpage ou broyage (« grinding » en anglais).

L'étape S11 illustrée par la figure 6A consiste à former successivement par épitaxie la couche de dérive 22, la couche de canal 23 et (de façon avantageuse) la couche de contact de source 24 sur la première face 21a du substrat 21.

Avantageusement, la première face 21a du substrat 21 est inclinée par rapport au plan c ({0001}) de la structure de maille hexagonale d'un angle compris entre 0,2° et 4° et de préférence entre 0,5° et 2° en direction du plan a ({1120}). Cette inclinaison réduit le nombre de défauts de croissance (surtout morphologiquement) dans les couches épitaxiées, notamment dans la couche de dérive 22.

Une couche métallique, par exemple en titane ou aluminium, peut être également déposée sur la couche de contact de source 24. Cette couche métallique est destinée à former une partie de l'électrode de source 25. Le dépôt d'une partie de l'électrode de source 25 sur l'empilement de couches épitaxiées, immédiatement après l'étape de croissance, permet de réduire la résistance électrique de l'électrode de source 25 et la résistance de contact avec la couche de contact de source 24.

Le premier procédé de fabrication comprend ensuite la formation de la structure de grille 27 du transistor.

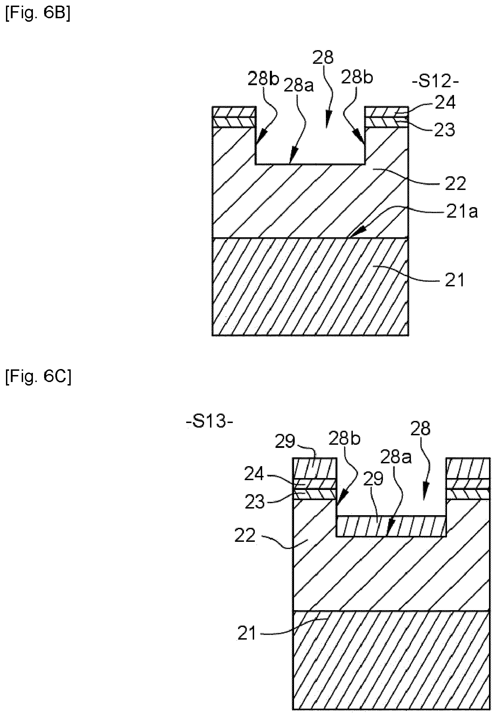

Dans un mode de mise en œuvre préférentiel du premier procédé de fabrication, la structure de grille 27 est une structure de grille MOS. Sa formation comprend avantageusement les étapes S12 à S15 représentées par les figures 6B à 6E.

A l'étape S12 de la figure 6B, une tranchée 28 est formée en gravant une partie de la couche de contact de source 24 et de la couche de canal 23 (et la couche métallique le cas échéant) jusqu'à atteindre la couche de dérive 22. Une portion supérieure plus ou moins épaisse de la couche de dérive 22 est également gravée, comme cela est illustré par la figure 6B.

La tranchée 28 possède un fond 28a et des parois latérales 28b. Les parois latérales 28b de la tranchée 28 s'étendent de préférence suivant une direction perpendiculaire à la première face 21a du substrat 21.

L'étape S13 de la figure 6C est une étape optionnelle consistant à former une couche de passivation 29, par exemple en SiO₂, sur la couche de dérive 22 au fond 28a de la tranchée 28 et sur la couche de contact de source 24. L'épaisseur de la couche de passivation 29 est par exemple comprise entre 100 nm et 800 nm.

La formation de la couche de passivation 29 peut comprendre les opérations suivantes :
- dépôt non-conforme d'un matériau de passivation, par exemple par dépôt chimique en phase vapeur assisté par plasma (PECVD), de manière à former une couche de matériau de passivation plus épaisse sur le fond 28a de la tranchée 28 et sur la couche de contact de source 24 que sur les parois latérales 28b de la tranchée 28 ; et
- gravure isotrope (par exemple gravure humide) de manière à éliminer le matériau de passivation sur les parois latérales 28b de la tranchée 28.

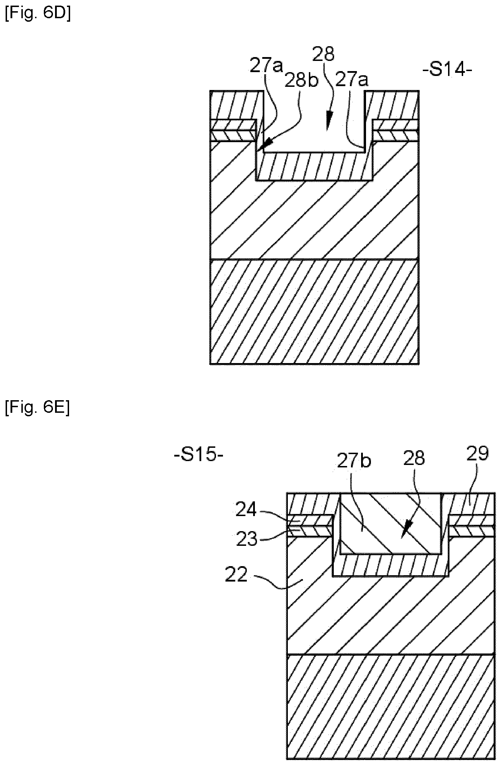

Puis, en S14 (Fig.6D), la couche diélectrique de grille 27a est formée contre les parois latérales 28b de la tranchée 28. La couche diélectrique de grille 27a peut être formée du même matériau que la couche de passivation 29 (ex. en SiO₂). En revanche, son épaisseur est inférieure à celle de la couche de passivation 29. Elle est par exemple comprise entre 20 nm et 100 nm.

La couche diélectrique de grille 27a est avantageusement formée en employant une technique de dépôt dite à haute température, telle que le dépôt chimique en phase vapeur à basse pression (LPCVD) ou le dépôt par couche atomique (ALD). Comparé aux autres techniques de dépôt (notamment la technique PECVD utilisée pour former la couche de passivation 29), ces techniques permettent d'obtenir une couche diélectrique de grille 27a de meilleure qualité, d'épaisseur constante (dépôt conforme) et procure un meilleur contrôle de son épaisseur.

A l'étape S15 de la figure 6E, la tranchée 28 est remplie d'un matériau électriquement conducteur, de préférence un métal, pour former l'électrode de grille 27b. La face inférieure de l'électrode de grille 27b se situe à la même hauteur que la face inférieure de la couche de canal 23 ou en dessous (suivant la profondeur de la tranchée 28, l'épaisseur de la couche diélectrique de grille 27a et l'épaisseur de la couche de passivation 29). Autrement dit, l'électrode de grille 27b s'étend verticalement dans la tranchée 28 au-delà de la couche de canal 23.

En référence à la figure 6D, le premier procédé de fabrication comprend ensuite une étape S16 de formation de l'électrode de source 25 sur la couche de contact de source 24. A cet effet, une ou plusieurs cavités sont gravées dans la couche de passivation 29 jusqu'à la couche de contact de source 24 puis ces cavités sont remplies de matériau électriquement conducteur, de préférence un métal.

Le substrat 21 est avantageusement aminci lors d'une étape S17 illustrée par la figure 6G, par exemple jusqu'à atteindre une épaisseur comprise entre 5 µm et 40 µm. L'amincissement sert à diminuer la contribution du substrat 21 à la résistance série du composant. Il peut être accompli par broyage ou par une technique appelée « écaillage » (« spalling » en anglais) et décrite dans le document [« Kerf-less removal of Si, Ge, and III-V layers by controlled spalling to enable low-cost PV technologies », Stephen W. Bedell et al., IEEE Journal of Photovoltaics, Vol. 2, No. 2, pp. 141-147, 2012].

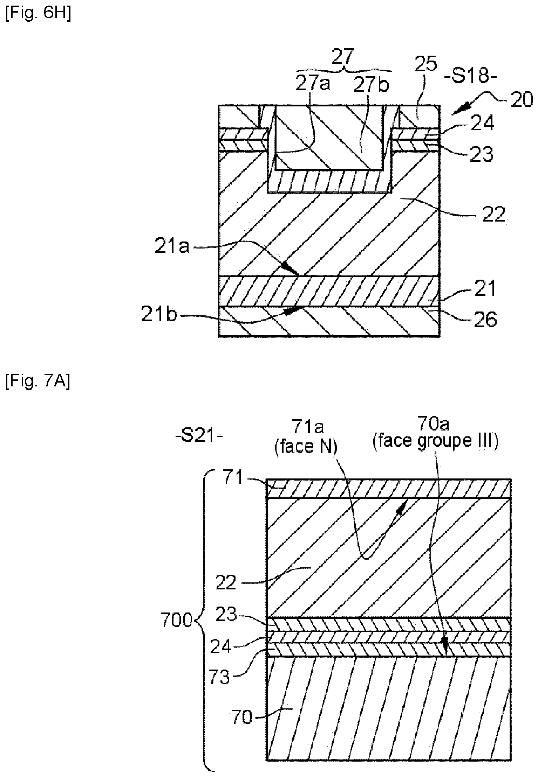

Enfin, à l'étape S18 de la figure 6H, l'électrode de drain 26 est formée sur la deuxième face 21B du substrat 21 (éventuellement aminci), de préférence par dépôt d'une (ou plusieurs) couche(s) de métal. L'électrode de drain 26 peut recouvrir toute la superficie de la deuxième face 21b du substrat 21 (dépôt « pleine plaque »).

La croissance par épitaxie sur la face de polarité N d'un substrat autoportant en matériau semi-conducteur III-N (tel que le substrat 21) est plus difficile que la croissance sur la face de polarité groupe III. Par ailleurs, un substrat autoportant à base de GaN présente souvent un taux de dislocations plus important en face N qu'en face Ga.

Ainsi, dans un deuxième procédé de fabrication du transistor 20 illustré par les figures 7A-7D, la croissance par épitaxie s'effectue dans l'ordre inverse sur une face de polarité groupe III, puis l'empilement de couches épitaxiées est retourné.

Les figures 7A à 7D représentent schématiquement des étapes S21 à S24 de ce deuxième procédé de fabrication.

Ce deuxième procédé de fabrication comprend tout d'abord la fourniture d'un substrat de croissance 70 comprenant une couche en matériau semi-conducteur III-N, par exemple en GaN ou AlGaN. Le substrat de croissance 70 comprend une première face 70a présentant une polarité de type groupe III. Le substrat de croissance 70 peut être en substrat autoportant en matériau semi-conducteur III-N, un substrat massif en matériau semi-conducteur III-N ou comprendre une couche de matériau semi-conducteur III-N disposée sur une couche de support, par exemple en saphir, en carbure de silicium ou en silicium.

L'étape S21 de la figure 7A consiste à former un empilement 700 en faisant croître successivement par épitaxie, sur la première face 70a du substrat de croissance 70, la couche de contact de source 24, la couche de canal 23, la couche de dérive 22 et une couche de semi-conducteur III-N 71.

Lors de l'épitaxie, le substrat de croissance 70 est ainsi orienté différemment du substrat 21 utilisé dans le premier procédé de fabrication (étape S11 de la figure 6A). Du fait de cette orientation, la face 71a de la couche de semiconducteur III-N 71 en contact avec la couche de dérive 22 présente une polarité de type N. La couche de semi-conducteur III-N 71 de la figure 7A correspond ainsi au substrat 21 de la figure 6G. Son épaisseur est de préférence comprise entre 0,5 µm et 2 µm. Elle est de préférence dopée de type n (10¹⁷ cm⁻³-10²⁰ cm⁻³).

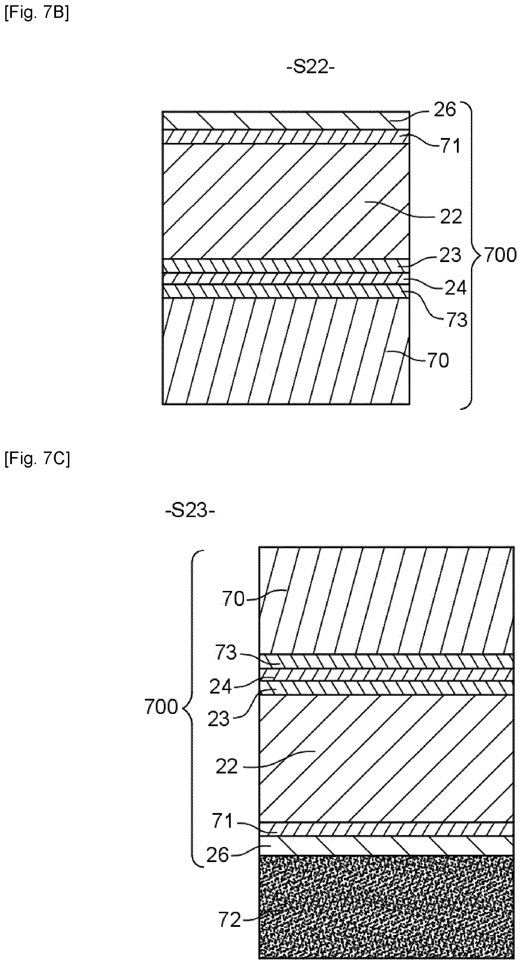

A l'étape S22 de la figure 7B, au moins une couche métallique est ensuite déposée sur la couche de semi-conducteur III-N 71 pour former l'électrode de drain 26. Cette couche métallique est également destinée à servir de couche de collage.

En S23 (Fig.7C), l'empilement 700 est retourné puis collé à un substrat de report 72 du côté de l'électrode de drain 26. Le substrat de report 72 est avantageusement en métal, par exemple en cuivre, afin d'améliorer la dissipation thermique du transistor 20 et la conductivité électrique de l'électrode de drain 26. Le collage est alors de type direct métal-métal (sans apport de matière).

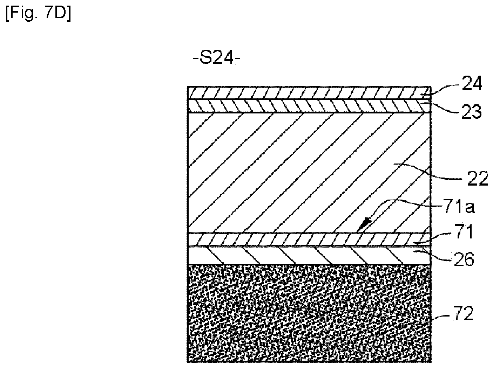

A l'étape S24 de la figure 7D, le substrat de croissance 70 est retiré de manière à exposer la couche de contact de source 24, par exemple par broyage ou décollement laser (« lift-off »).

Enfin, la structure de grille 27 et l'électrode de source 25 du transistor 20 sont formées, de préférence de la façon décrite en relation avec les figures 6B à 6F (étapes S12 à S16).

Ce deuxième procédé de fabrication présente l'avantage de limiter les défauts de croissance dans la structure (verticale) du transistor 20. Il est cependant plus long à mettre en œuvre.

Avantageusement, l'empilement 700 comprend en outre une couche d'arrêt 73, formée par épitaxie sur la première face 70a du substrat de croissance 70 avant la couche de contact de source 24 (ou la couche de canal 23). Cette couche d'arrêt 73, par exemple en AlGaN, facilite le retrait du substrat de croissance 70. En effet, le substrat de croissance 70 est alors retiré en deux temps, d'abord par broyage ou décollement laser sur plusieurs centaines de micromètres, puis l'épaisseur restante est retirée par gravure en s'arrêtant sur le couche d'arrêt 73. A l'issue de l'étape de retrait du substrat de croissance 70, la couche 73 est retirée par gravure avec arrêt sur la couche de contact de source 24 (ou sur la couche de canal 23).

Une charge piézoélectrique d'interface entre la couche de dérive et la couche de canal peut être également obtenue dans un transistor (vertical) à effet de champ à canal p (p-FET), en disposant ces couches sur la face de polarité groupe III de la couche de semi-conducteur III-N 21/71.

Ainsi, un autre aspect de l'invention concerne un transistor à effet de champ à canal p, comprenant :
- une couche de semi-conducteur III-N comprenant une première face et une deuxième face opposée à la première face, la première face présentant une polarité de type groupe III ;
- une couche de dérive disposée sur la première face de la couche de semi-conducteur III-N ;
- une couche de canal disposée sur la couche de dérive, la couche de canal formant une hétérostructure avec la couche de dérive ;
- de préférence, une couche de contact de source disposée sur la couche de canal ;
- une structure de grille s'étendant jusqu'à la couche de dérive à travers la couche de canal et, le cas échéant, la couche de contact de source ;
- une électrode de source disposée sur la couche de canal, ou le cas échéant, sur la couche de contact de source ; et
- une électrode de drain disposée sur la deuxième face de la couche de semi-conducteur III-N.

La couche de semi-conducteur III-N, la couche de dérive et la couche de contact de source du transistor p-FET sont dopées de type p, plutôt que de type n. En blocage et en conduction, l'électrode de drain du transistor p-FET est polarisée négativement (et non positivement comme dans le cas d'un transistor n-FET).

## Revendications

1. Transistor à effet de champ (20) comprenant :
- une couche de semi-conducteur III-N (21) comprenant une première face (21a) et une deuxième face (21b) opposée à la première face ;
- une couche de dérive (22) disposée sur la première face (21a) de la couche de semi-conducteur III-N (21) ;
- une couche de canal (23) disposée sur la couche de dérive (22) ;
- une structure de grille (27) s'étendant jusqu'à la couche de dérive (22) à travers la couche de canal (23) ;
- une électrode de source (25) disposée sur la couche de canal (23) ; et
- une électrode de drain (26) disposée sur la deuxième face (21b) de la couche de semi-conducteur III-N (21) ;
ledit transistor étant **caractérisé en ce que** la première face (21a) de la couche de semi-conducteur III-N (21) présente une polarité de type azote (N) et **en ce que** la couche de canal (23) forme une hétérostructure avec la couche de dérive (22).

2. Transistor (20) selon la revendication 1, dans lequel la couche de semi-conducteur III-N (21) est en nitrure de gallium (GaN) ou en nitrure d'aluminium-gallium (AlGaN).

3. Transistor (20) selon la revendication 2, dans lequel la couche de dérive (22) est en nitrure de gallium (GaN) dopé n et la couche de canal (23) est en nitrure d'aluminium-gallium (AlGaN) dopé p ou non-intentionnellement dopé.

4. Transistor (20) selon la revendication 3, dans lequel le nitrure d'aluminium-gallium (AlGaN) de la couche de canal (23) présente un pourcentage d'aluminium compris entre 20 % et 40 %.

5. Transistor (20) selon l'une des revendications 3 et 4, dans lequel la couche de canal (23) présente une épaisseur comprise entre 10 nm et 20 nm.

6. Transistor (20) selon la revendication 2, dans lequel la couche de dérive (22) est en nitrure d'aluminium-gallium (AlGaN) dopé n et la couche de canal (23) est en nitrure d'aluminium (AlN) dopé p ou non-intentionnellement dopé.

7. Transistor (20) selon la revendication 2, dans lequel la couche de dérive (22) est en nitrure d'aluminium-gallium (AlGaN) dopé n et la couche de canal (23) est en un nitrure d'aluminium-gallium (AlGaN) dopé p ou non-intentionnellement dopé et présentant un pourcentage d'aluminium supérieur à celui de la couche de dérive (22).

8. Transistor (20) selon l'une quelconque des revendications 1 à 7, comprenant en outre une couche de contact de source (24) disposée entre la couche de canal (23) et l'électrode de source (25).

9. Transistor (20) selon la revendication 8, dans lequel la couche de contact de source (24) est en nitrure de gallium (GaN) dopé de type n.

10. Procédé de fabrication d'un transistor à effet de champ (20), comprenant les étapes suivantes :
- fournir un substrat (21) en un matériau semi-conducteur III-N, le substrat comprenant une première face (21a) présentant une polarité de type azote (N) et une deuxième face (21b) opposée à la première face ;
- former (S11) successivement par épitaxie une couche de dérive (22) et une couche de canal (23) sur la première face (21a) du substrat (21), la couche de canal (23) formant une hétérostructure avec la couche de dérive (22) ;
- former (S12-S15) une structure de grille (27) s'étendant jusqu'à la couche de dérive (22) à travers la couche de canal (23) ;
- former (S16) une électrode de source (25) sur la couche de canal (23) ; et
- former (S18) une électrode de drain (26) sur la deuxième face (21b) du substrat (21).

11. Procédé selon la revendication 10, comprenant en outre une étape (S17) d'amincissement du substrat (21) avant l'étape (S18) de formation de l'électrode de drain (26).

12. Procédé de fabrication d'un transistor à effet de champ (20), comprenant les étapes suivantes :
- fournir un substrat de croissance (70) comprenant une couche en un matériau semi-conducteur III-N, le substrat de croissance comprenant une première face (70a) présentant une polarité de type groupe III ;
- former (S21) un empilement (700) en faisant croître successivement par épitaxie une couche de canal (23), une couche de dérive (22) et une couche de semi-conducteur III-N (71) sur la première face (70a) du substrat de croissance (70), la couche de canal (23) formant une hétérostructure avec la couche de dérive (22) ;
- déposer (S22) au moins une couche métallique sur la couche de semi-conducteur III-N (71) pour former une électrode de drain (26) ;
- retourner (S23) l'empilement (700) et le coller à un substrat de report (72) du côté de l'électrode de drain (26) ;
- retirer (S24) le substrat de croissance (70) ;
- former (S12-S15) une structure de grille (27) s'étendant jusqu'à la couche de dérive (22) à travers la couche de canal (23) ; et
- former (S16) une électrode de source (25) sur la couche de canal (23).

13. Procédé selon la revendication 12, dans lequel le substrat de report (72) est en métal.

14. Procédé selon l'une des revendications 12 et 13, dans lequel l'empilement (700) comprend en outre une couche d'arrêt (73) formée par épitaxie sur la première face (70a) du substrat de croissance (70) avant la couche de canal (23).

15. Procédé selon la revendication 14, dans lequel la couche d'arrêt (73) est en nitrure d'aluminium-gallium (AlGaN).
